# EUROPEAN PATENT APPLICATION

(11) **EP 2 317 388 A2**
(43) Date of publication of application: **04.05.2011**
(21) Application number: 10189134.9
(22) Date of filing: 27.10.2010
(51) Int. Cl.: G03F 7/20

(54) **Method and system for wafer inspection**

(30) Priority: 28.10.2009 US 255664 P
(71) Applicant: IMEC, 3001 Leuven (BE); Hitachi High-Technologies Corporation, Tokyo 105-8717 (JP)
(72) Inventor: Wiaux, Vincent Jean-Marie Pierre Paul, 1348, Louvain-la-Neuve (BE); Matsuoka, Ryoichi, Chiba-ken Chiba (JP); Koshihara, Shunsuke, Ibaraki-ken Ibaraki (JP); Sakai, Hideo, Tokyo-to Tokyo (JP)
(74) Representative: Wauters, Davy Erik Angelo

(57) **Abstract**

A method (200) is disclosed for evaluating a lithographic pattern (450) that is obtained using multiple patterning lithographic processing according to a target design (410) composed of a first design (420) and at least a second design (430). In one aspect, the method (200) includes aligning (220) the target design (410) with the lithographic pattern (450). The method further includes identifying (230) a stitching region in the lithographic pattern based on a region of overlap (440) of the first design (420) and the second design (430) in the target design (410) aligned with the lithographic pattern (450) and determining (240) for the identified stitching region in the lithographic pattern (450) whether a predetermined criterion is fulfilled.

## Description

### Field of the Invention

The present invention relates to the field of lithographic processing of devices, e.g. in semiconductor processing. More particularly, the present invention relates to methods and systems for evaluating a lithographic pattern obtained using multiple patterning lithographic process.

### Background of the invention

In the production of today's integrated circuits, optical lithography is one of the key manufacturing techniques. In order to cope with the ongoing miniaturization of integrated circuits or other devices and its associated problems, new lithographic techniques need to be introduced. Possibilities used nowadays (45nm technology node and below) are high numerical aperture solutions such as immersion lithographic processing and extreme ultraviolet (EUV) lithographic processing. In order to meet the resolution requirements of the 32nm technology node and below new solutions have to be introduced such as double patterning lithography, which could bridge between conventional immersion lithography and EUV lithography.

In conventional single patterning lithography one exposure step of the wafer is performed, followed by one development step. The wafer stays in the lithographic exposure tool for the full exposure.

In multiple patterning lithography multiple exposure steps and multiple development steps are performed. One example of multiple patterning lithography is double patterning lithography, wherein two exposure steps and two development steps are used. The wafer is exposed and developed for a first time using a first mask, and next exposed and developed for a second time with a second mask. In between the first lithographic step using the first mask and the second lithographic step using the second mask, the wafer is etched or processed in order to freeze the first patterning. This lithographic integration flow is also often referred to as litho-etch-litho-etch or litho-process-litho approach. The use of a first and a second mask involves splitting of a (desired final) design into two separate designs, which typically are more sparse designs than the desired final design. After the double patterning lithographic step, both designs are combined together into the desired final design. Double patterning requires thus cutting and splitting of the design in separate sub-designs, wherein each sub-design is patterned separately and thus recombined. The complexity of design split, required when applying double patterning, strongly depends on the pattern density and its two-dimensional (2D) content. Consequently, a lot of attention is needed for devices with a dense pattern.

In double patterning of random logic applications with small pitch, distributing existing polygons on two separate designs may not be sufficient. Often cutting of such polygons is required. However, this result in creating new line-ends that needs to recombine during the double patterning process at so-called stitching points. The 2D printability of the patterns needs to be taken into account to validate the benefit of a split. Small gaps at line-ends and critical 2D topologies may be as important as sub-resolution-or forbidden-pitches.

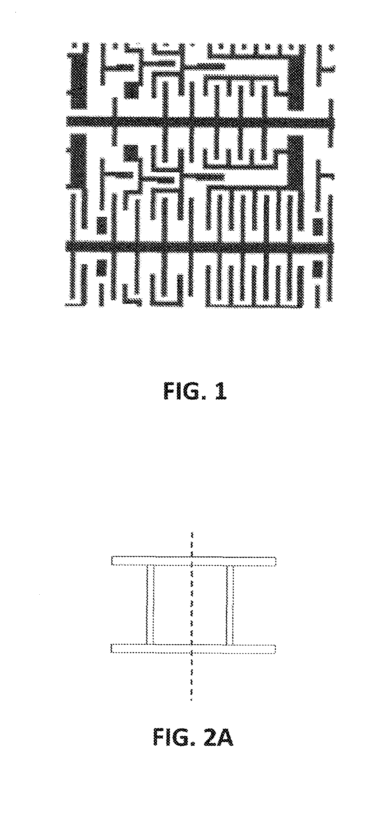

Figure 1 shows an example of such a 45nm half pitch random logic metal layout which needs cutting and stitching.

In view of effects of improper stitching on the yield for devices made, there is a need for measurement techniques and/or metrology methods for evaluating stitching and/or patterning in a multiple patterning lithographic process or in devices thus obtained.

### Summary of the invention

Certain inventive aspects relate to methods and systems for evaluating a multiple patterning lithographic processing or the devices obtained thereby. It is an advantage of embodiments of the present invention that a qualitative and/or quantitative evaluation of a multiple patterning lithographic process or the stitching applied thereby can be obtained. It is an advantage of embodiments according to the present invention that methods and systems are provided allowing process control of a multiple patterning lithographic process. It is an advantage of embodiments of the present invention that methods and systems are provided for detecting weaker points in a pattern through process variations when applying multiple patterning lithographic processing. It is an advantage of embodiments according to the present invention that methods and systems are provided allowing evaluation of each of the patterning steps used during multiple patterning as well as evaluation of stitching points where the different patterns used for multiple patterning are recombined.

It is an advantage of embodiments according to the present invention that accurate measurement of the critical dimension (CD) and overlay after multiple patterning lithography can be performed to determine whether the recombination or stitching of different patterns/designs/polygons during multiple patterning lithographic processing was done properly and within the needed specifications. It is an advantage of embodiments according to the present invention that these allow distinguishing between different populations of polygons issued from different patterning steps during multiple patterning lithographic processing.

One inventive aspect relates to a method for evaluating a lithographic pattern, the lithographic pattern being obtained using multiple patterning lithographic processing according to a target design composed of a first design and at least a second design, the method comprising aligning the target design with the lithographic pattern, identifying a stitching region in the lithographic pattern based on a region of overlap of the first design and the second design in the target design aligned with the lithographic pattern, and determining for the identified stitching region in the lithographic pattern whether a predetermined criterion is fulfilled. It is an advantage of embodiments according to the present invention that accurate localization of stitching regions in the lithographic processing can be performed, resulting in the possibility for improved characterization and control of stitching in multiple patterning lithographic processing and/or in improved structures thus obtained.

Aligning the target design with the lithographic pattern may comprise aligning the first design to a first set of lithographic pattern features and/or aligning the second design to a second set of lithographic pattern features, thus distinguishing the first set of lithographic pattern features generated using the first design and the second set of lithographic pattern features generated using the second design on the lithographic pattern. It is an advantage of embodiments according to the present invention that not only localization of stitching regions can be performed but that also distinguishing between features induced by the first design and features induced by the second design can be performed, allowing a separate evaluation of the first patterning step and the at least second patterning step of the multiple patterning process. The latter furthermore allows good separate control and/or adjustment of the different patterning steps in the multiple patterning processes.

Aligning may comprise extracting a position of an edge of the lithographic pattern based on an image thereof, and combining the target design and the image of the lithographic pattern taking into account the extracted position of the edge. It is an advantage of embodiments according to the present invention that known techniques can be used for aligning. It is an advantage that accurate aligning can be performed, reducing accuracy errors for determining one or more stitching regions.

Determining for the identified stitching region in the lithographic pattern whether a predetermined criterion is fulfilled may comprise determining a stitching metric for the identified stitching region and evaluating whether or not the stitching metric fulfills a predetermined criterion. It is an advantage of embodiments according to the present invention that a qualitative and/or quantitative characterization of the stitching can be performed, thus allowing good evaluation of the obtained lithographic pattern or the method for obtaining such a pattern. Determining a stitching metric may comprise determining an edge placement error along at least one edge of the lithographic pattern in the stitching region and evaluating whether the edge placement error is below a predetermined threshold for the edge placement error. It is an advantage of embodiments according to the present invention that techniques for edge placement error measurements are available, as for example described in the article "The challenge of new metrology world by CD-SEM and Design" by Koshihara et al. in Industrial Systems 58 (3) 2008, the invention not being limited thereto. The method may comprise determining for a plurality of points of the at least one edge of the lithographic pattern an edge placement error and taking these edge placement errors into account for determining the predetermined threshold value for the edge placement error, e.g. for edge placement errors to be determined in the future or for deciding which edge placement errors should not be considered. It is an advantage of embodiments according to the present invention that edge placement errors induced by a critical dimension change with a certain roughness independent of the stitching can be identified, allowing a more accurate evaluation of the actual edge placement error induced by stitching and thus of the actual stitching quality. The method further may comprise, based on said evaluating, deciding that necking problems are present due to stitching when a local deviation of the edge placement error is larger than the predetermined threshold. Determining a stitching metric furthermore may comprise determining an edge placement error along a second edge in the stitching region opposite the at least one edge, evaluating an edge placement error for the second edge and combining information regarding the edge placement error of the at least one edge and the edge placement error of the second edge. It is an advantage of embodiments according to the present invention that edge placement errors for the lithographic pattern can be taken into account, resulting in a more accurate evaluation and optional correction of the stitching.

The method furthermore may comprise focusing on the identified stitching region. Focusing on the identified stitching region may comprise obtaining a detailed or enlarged image of the identified stitching region. It is an advantage of embodiments according to the present invention that the image used for determining whether the identified stitching region in the lithographic pattern fulfills a predetermined criterion can be enlarged, e.g. in comparison with the image used for aligning. The latter may result in a more accurate characterization of identified stitching regions, i.e. of the critical area for stitching inspection, which may be considered as weak points in the lithographic pattern. In this way, by identification and evaluation of the stitching regions, improved patterns and corresponding devices and circuits can be obtained.

The method may comprise for the distinguished first set of lithographic pattern features and second set of lithographic pattern features separately determining whether a predetermined criterion is fulfilled. It is an advantage of embodiments according to the present invention that evaluation can be made of the separate patterning steps as well as of the stitching step, thus resulting in a high overall accurate evaluation. It is an advantage of embodiments according to the present invention that each set of lithographic pattern features and consequently each patterning step of the multiple patterning step can be subjected separately to process control inspection.

Determining for the identified stitching region in the lithographic pattern whether a predetermined criterion is fulfilled may comprise determining a line or trench minimum width. Determining a line or trench minimal width may comprise determining at least one edge position on a first edge of a pattern and a plurality of edge positions on a different edge facing the first edge, determining values for the plurality of distances between the at least one edge position on the first edge and the plurality of edge positions on the different edge, and selecting a minimum value from said determined values as the line or trench minimum width. Determining the at least one edge position and the plurality of edge positions comprises selecting edge positions from within a selection region, such that distances can be measured in all directions where neighbouring edge points of different edges are present. In other words the selection region may be such that measurement in all directions should be possible.

Another inventive aspect relates to a method for evaluating a multiple patterning lithographic process, the method comprising making a lithographic pattern using the multiple patterning lithographic process, performing a method for evaluating a lithographic pattern as described above, and determining based thereon whether the multiple patterning lithographic process fulfills predetermined requirements.

Another inventive aspect relates to a method for optimizing a multiple patterning lithographic process, the method comprising evaluating a multiple patterning lithographic process as described above and adjusting one or more of the process parameters, e.g. the design split used, of the multiple patterning lithographic process if it is found that the predetermined requirements are not fulfilled.

Another inventive aspect relates to a method for inspecting a wafer, the wafer comprising at least a lithographic pattern, the method comprising evaluating the lithographic pattern as described above.

Another inventive aspect relates to an inspection system for evaluating a lithographic pattern, the lithographic pattern being obtained using multiple patterning lithographic processing according to a target design composed of a first design and at least a second design, the inspection system comprising an aligning module adapted for aligning the target design with the lithographic pattern, an identification module adapted for identifying a stitching region in the lithographic pattern based on a region of overlap of the first design and the second design in the target design aligned with the lithographic pattern, and a determination module adapted for determining for the identified stitching region in the lithographic pattern whether a predetermined criterion is fulfilled. Another inventive aspect relates to a method for determining a line or trench width, the method comprising determining at least one edge position on a first edge of a pattern and a plurality of edge positions on a different edge facing the first edge, determining values for the plurality of distances between the at least one edge position on the first edge and the plurality of edge positions on the different edge, and selecting a minimum value from said determined values as the line or trench minimum width. Determining the at least one edge position and the plurality of edge positions may comprise selecting edge positions from within a selection region, such that distances can be measured in all directions where neighboring edge points of different edges are present. In other words the selection region may be such that measurement in all directions should be possible.

Another inventive aspect relates to a computer program product adapted for, when executed on a computer, performing a method for evaluating a lithographic pattern as described above or a method for determining a trench or line minimal width as described above.

Another inventive aspect relates to a machine readable data storage device storing the computer program product as described above and/or to the transmission of such a computer program product over a local or wide area telecommunications network.

Certain embodiments of the present invention give rise to improved methods and systems for performing multiple patterning lithographic processing and/or to improved devices obtained using multiple patterning lithographic processing.

The above and other characteristics, features and advantages of certain inventive aspects will become apparent from the following detailed description, taken in conjunction with the accompanying drawings. This description is given for the sake of example only, without limiting the scope of the invention.

### Brief description of the drawings

All drawings are intended to illustrate some aspects and embodiments of the present invention. The drawings described are only schematic and are non-limiting. In the drawings, the size of some of the elements may be exaggerated and not drawn on scale for illustrative purposes. It is intended that the figures disclosed herein be considered illustrative rather than restrictive.
FIG. 1 represents an example of such a 45nm half pitch random logic metal layout which needs cutting and stitching.
FIG. 2A and 2B represent an example of a cutting/stitching pattern.
FIG. 3 shows a schematic representation of an exemplary method for evaluating a lithographic pattern according to an embodiment of the first aspect of the present invention.
FIG. 4 illustrates a first example of a split line pattern of a target design aligned with a lithographic pattern, as can be used in an embodiment of the present invention.
FIG. 5 illustrates an enlarged view of a stitching region in the split line pattern of FIG. 4.
FIG. 6 illustrates a second example of a split line pattern of a target design aligned with a lithographic pattern, as can be used in an embodiment of the present invention.
FIG. 7 illustrates an enlarged view of a stitching region in the split line pattern of FIG. 6.
FIG. 8A and FIG. 8B illustrate examples of stitching regions for the patterns as shown in FIG. 4 and FIG. 6 respectively
FIG. 9 is a schematic overview of the use of EPE data for evaluating stitching, as can be obtained using a method according to an embodiment of the present invention.
FIG. 10 illustrates experimental results for determining the quality of stitching for a lithographic pattern, using a method according to an embodiment of the present invention.
FIG. 11 illustrates a first example of stitching of two line ends and corresponding EPE data, as can be used in a method according to an embodiment of the present invention.
FIG. 12 illustrates a diagrammatic overview of a method for evaluating lithographic processing according to an embodiment of the present invention.
FIG. 13 illustrates a diagrammatic overview of a method for evaluating lithographic processing according to a different embodiment of the present invention.
FIG. 14 illustrates an inspection system according to an embodiment of the present invention.
FIG. 15 illustrates different positions for evaluation of stitching based on EPE data for a pattern comprising different lines, as shown in FIG. 10.
FIG. 16a to Fig. 16e illustrates EPE data for different lines obtained at different positions on the constituted line.
FIG. 17 illustrates the definition of minimum stitching width, illustrated on a design, a simulated pattern and an experimental pattern, as can be used in embodiments of the present invention.
FIG. 18 illustrates the determination of edge positions and determination of the distance between edge positions, according to one embodiment of the present invention.
FIG. 19 illustrates the determination of edge positions and the determination of the minim distance for a feature with particular orientation according to an embodiment of the present invention.
FIG. 20 illustrates the line minimal width as function of the overlap provided for in the design, according to an embodiment of the present invention.

### Detailed description of illustrative embodiments

One or more embodiments of the present invention will now be described in detail with reference to the attached figures, the invention is not limited thereto. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention. Those skilled in the art can recognize numerous variations and modifications of this invention that are encompassed by its scope. Accordingly, the description of preferred embodiments should not be deemed to limit the scope of the present invention.

Furthermore, the terms first, second and the like in the description are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description are used for descriptive purposes and not necessarily for describing relative positions. The terms so used are interchangeable under appropriate circumstances and the embodiments of the invention described herein can operate in other orientations than described or illustrated herein. For example "underneath" and "above" an element indicates being located at opposite sides of this element.

It is to be noticed that the term "comprising" should not be interpreted as being restricted to the means listed thereafter; it does not exclude other elements or steps. Thus, the scope of the expression "a device comprising means A and B" should not be limited to devices consisting only of components A and B. It means that with respect to the present invention, the only relevant components of the device are A and B.

The term "edge placement error" as referred to in this application is used to refer to the function expressing the difference between the design intent and the printed pattern. It also may be referred to as EPE. It may be expressed as the distance (e.g. expressed in nanometer) between the design and the printed pattern for a design aligned with the pattern.

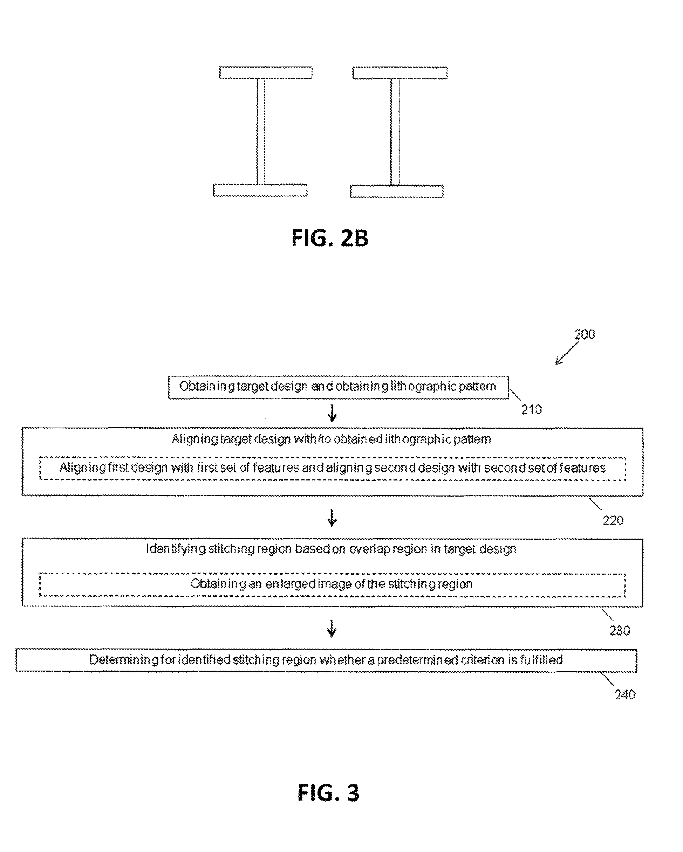

In the present application, when reference is made to splitting or design splitting, reference is made to the division of design features in two or more sets of features, the design features being design features of a pattern to be applied in a single layer. The latter thus results in the application of multiple patterning for forming a pattern in a single layer. Splitting of the design also may refer to cutting and stitching, i.e. cutting of certain features in parts or smaller features, at least partly patterning them and stitching the sub-features together so as to obtain the features as targeted in the single layer. Splitting thus refers to cutting features in smaller pieces and thereafter bringing them back together after at least part of the processing. Cutting and stitching thus refers only to cutting on the features so that different features being part of the target feature are created and brought back together after at least part of the processing. FIG. 2A, 2B illustrate an example of a cutting and stitching design. The target design is given on the left hand side whereas the split design is given on the right hand side. The dashed line (FIG. 2A) illustrates the splitting line. The target design is subdivided into two sets of features.

It is an advantage of some embodiments according to the present invention that these are especially suitable for studying two dimensional patterns, i.e. patterns that comprise components oriented in or perpendicular to orientations different from X or Y direction. It is an advantage of some embodiments according to the present invention that these allow measurements in any direction, e.g. any direction between facing edges.

However, splitting a pattern in different sets of features may create new line-ends which need to be recombined by the multiple patterning process at so called stitching-points. These stitching points are potential weak points through process variation, as such possibly affecting the yield. Therefore process control does not only require the control of each patterning process step, but also the control of the stitching points.

In a first aspect, the present invention relates to a method for evaluating a lithographic pattern obtained using multiple patterning lithographic processing and made according to a target design composed of a first design and at least a second design. Multiple patterning lithographic processing may for example be double patterning lithographic process, whereby the creation of features in a pattern in a single layer comprises at least a first patterning step of a first set of lithographic patterning features and a second patterning step of at least a second set of lithographic patterning features. Alternatively, creation of features in a pattern using more than two patterning steps before developing the resist also is envisaged. It is possible (but not necessary) that a development step is included in between each patterning step. Multiple patterning lithographic processing also may include different etching steps for the different exposure and development steps, although the invention is not limited thereby. As indicated above, double patterning lithographic processing is one example of a multiple patterning lithographic processing wherein two exposure steps are used. Where in the present application reference is made to double patterning lithographic processing or to steps thereof, this may be mutates mutandis replaced by multiple patterning or steps thereof. The different designs used in multiple patterning lithographic processing may be introduced by subsequently applying conventional lithography processes for the individual designs.

For multiple patterning lithography, the target design is split or cut into two or more designs, i.e. a first design and at least a second design. Such designs typically may be more sparse, allowing an easier patterning of that part of the design compared to patterning of the full design. The selection of a good design split of the target design into at least a first and a second design may have an important impact on the success of multiple patterning. The design split for multiple patterning lithographic processing may involve complex polygon splitting, i.e., splitting of the target design in different polygons. By applying the different patterning processes according to the different designs, the different polygons can be recombined again into the lithographic pattern. Selection of design split may for example be performed using predetermined design rules. The target design may comprise OPC features or other assist features necessary for the patterning step(s).

The method for evaluating according to embodiments of the first aspect of the present invention comprises aligning the target design with the lithographic pattern, identifying a stitching region in the lithographic pattern based on a region of overlap of the first design and the second design in the target design aligned with the lithographic pattern, and determining for the identified stitching region in the lithographic pattern whether a predetermined criterion is fulfilled. Whereas in the present embodiments reference is given to stitching and stitching regions, embodiments of the present embodiments encompass a corresponding method for more general necking metrology. Embodiments of the present invention may be used to measure a minimum distance in any direction to measure any patterning issue leading to necking, in each of the lithography steps or in their combination through the multiple patterning process flow. By way of illustration, the present invention not being limited thereto, a more detailed description of different standard and optional steps of an exemplary method for evaluating a lithographic pattern as shown in FIG. 3, will be given below.

In optional step 210, the method 200 comprises obtaining a target design composed of a first design and at least a second design and obtaining a lithographic pattern to be evaluated. The target design is the desired design to be patterned. Alternatively, the target design and the lithographic pattern, e.g. provided on a substrate like a wafer, may already be available. Obtaining the target design and the lithographic pattern may be performed by obtaining a previously made target design and by obtaining a lithographic pattern made by multiple patterning lithographic processing according to this target pattern. Alternatively, obtaining the target design may involve generating a target design using conventional techniques for generating a target design and obtaining a lithographic pattern may involve generating a lithographic pattern using multiple patterning lithographic processing according to the generated target design.

In step 220, the obtained target design and the lithographic pattern are aligned with respect to each other. The target design therefore may be aligned with the lithographic pattern as e.g. obtained on the wafer by the multiple patterning process. In some embodiments, the target design is aligned with an image, e.g. a scanning electron microscope image, of the lithographic pattern. Such alignment may for example be performed using a microscope comprising specific tool for mapping a design to a pattern or an image thereof. The scanning electron microscope used for such applications may for example be a critical dimension - scanning electron microscope, which may already be part of the analysis tool set for analyzing a lithographic pattern. An example for aligning a target design to the lithographic pattern on wafer is described in the article "The challenge of new metrology world by CD-SEM and Design" by Koshihara et al. in Industrial Systems 58 (3) 2008. According to such an example, alignment may be performed by extracting an edge of the lithographic pattern e.g. in a SEM image, repositioning the extracted edge and the target design data and optionally performing a final alignment. Aligning the target design with the lithographic pattern or an image thereof results in an automatic aligning of the first design and second design to the lithographic pattern.

Optionally, in some embodiments, the invention not being limited thereto, aligning the target design with/to the lithographic pattern on wafer or an image thereof may comprise separately aligning the at least first design with a first set of lithographic patterning features and aligning the at least second design with a second set of lithographic patterning features. This separate alignment results in that the features, such as e.g. polygons, on the lithographic pattern thus can be distinguished as belonging either to a first set of lithographic pattern features generated using the first design or to a second (or further) set of lithographic pattern features generated using the second design on the lithographic pattern. Although as a result of splitting the target design for performing multiple patterning, the features e.g. polygons are distributed onto different layers in the design and although, after multiple patterning, it is hard to distinguish the different patterning populations, i.e. the different sets of lithographic patterning features, this difficulty is overcome by this form of aligning. In other words, by aligning the at least first and second design to the lithographic pattern on the wafer separately, each layer can be used independently to identify the patterning origin of the various parts of the final polygons and to guide the process control inspection of each population. Furthermore, such separate alignment may result in a better alignment of the first design and second design with the lithographic pattern.

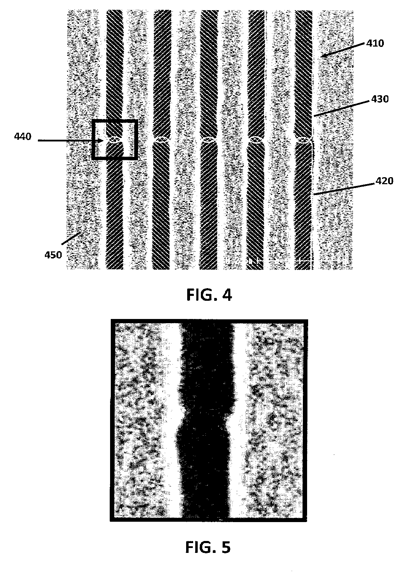

FIG. 4 shows an example of a split line pattern wherein the lithographic pattern 450 on wafer (in the present example being a SEM image of the printed pattern) is aligned with the target design 410 (target design 410 is corresponding with the combination of the first design 420 and the second design 430). More specifically, in the present example, the first design 420 is aligned with the first lithographic pattern and the second design 430 is aligned with the second lithographic pattern. The overlap region 440 is determined by the area where the first design 420 and the second design 430 overlap. FIG. 5 shows a zoomed image of a stitching region of the lithographic pattern 450, as will be discussed later.

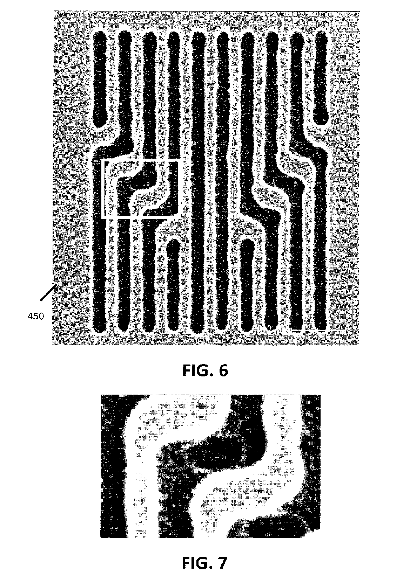

FIG. 6 shows another example of a split line pattern wherein the lithographic pattern 450 on wafer (in the present example being a SEM image of the printed pattern) is aligned with the target design. FIG. 7 shows a zoomed image of a stitching region of the lithographic pattern 450, as will be discussed later.

The method according to embodiments of the present invention furthermore comprises, as indicated in step 230 in FIG. 3, identifying a stitching region in the lithographic pattern 450 based on a region of overlap 440 of the first design 420 and the second design 430 in the target design 410 aligned with the lithographic pattern 450. The stitching region may be defined as the region or area in the lithographic pattern 450 where the first set of lithographic pattern features and the second set of lithographic pattern features recombine. Depending on the process conditions of the lithographic process(es) the stitching region comprises no overlap, a point of contact or overlap between the at least a first lithographic patterning set and the at least a second lithographic patterning set. The possibility for identifying the stitching region on the lithographic pattern allows more accurate control of the stitching. The latter is advantageous as the stitching area is one of the critical points induced by splitting the target design and more accurately control of these critical points may result in improved lithographic patterns or methods for making them.

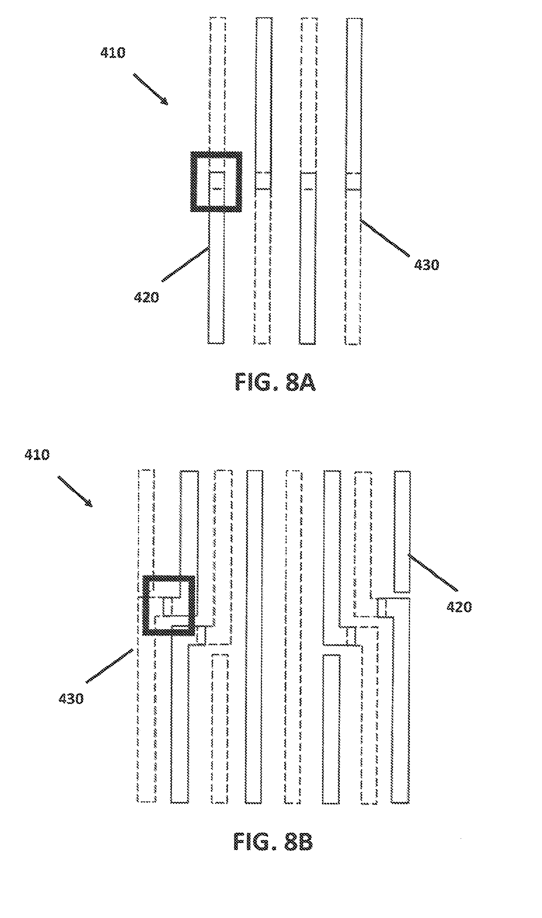

Examples of stitching regions for the patterns as shown in FIG. 4 and FIG. 6 are illustrated in FIG. 8A and FIG. 8B respectively. FIG. 8A shows a target design 410, being a line pattern with dense pitch, cut into a first design (solid line) 420 and a second design (dotted line) 430. A stitching region, as identified by the region in the aligned target design where the first 420 and second design 430 meet or overlap, is shown for one line (being a combination of a line from the first design 420 and a line from the second design 430) in the indicated rectangle. Figure 8B shows a more complex target design 410, being a pattern with dense pitch, cut in a turn into a first design (solid line) 420 and a second design (dotted line) 430. A stitching region for one line (being a combination of a line from the first design and a line from the second design) again is shown in the indicated rectangle.

For identifying the stitching region, an image may be used, such as for example an image obtained with an electron beam, advantageously a secondary electron beam (part of a secondary electron microscopy SEM). Identification of the stitching region may be performed and the field of view of the image may be limited to the area of inspection, i.e. the stitching region. Identification of the stitching region may for example be performed using a secondary electron microscope.

In some embodiments, the method 200 may comprise enlarging or upsizing the region of interest, i.e. the stitching region, allowing a more accurate inspection of the area. This may for example be done by zooming in on the region of interest. By way of illustration, the present invention not being limited thereby, examples of enlarged images of stitching regions in FIG. 4 and FIG. 6 are shown in FIG. 5 and FIG. 7.

Embodiments of the present invention furthermore comprise determining 240 for the identified stitching region in the lithographic pattern 450 whether a predetermined criterion is fulfilled. The latter may allow evaluation of the lithographic pattern 450 so that it can be decided whether or not the lithographic pattern 450 is within the required specifications. In embodiments according to the present invention, qualitative and/or quantitative evaluation of the stitching quality for a multiple patterning process on wafer may be performed. A qualitative assessment of the stitching points may for example comprise detecting different process failure, such as for example an incomplete OPC, the occurrence of bridging, the occurrence of pinching and/or the occurrence of a stitching error.

Determining 240 whether the identified stitching area fulfils a predetermined criterion may also be performed using a stitching metric. The stitching metric may thus express the quality of the splitting correlated process. One example of a stitching metric is a stitching metric expressing the lack of occurrence of bridging around the stitching point. Another example of a stitching metric that may be used is a stitching metric expressing a degree of completeness of OPC, a metric expressing the occurrence of pinching, a metric expressing the occurrence of a stitching error, etc. The metric may also directly express a stitching parameter, for example it may express a degree of stitching between design features patterned in the first patterning and design features patterned in the second patterning step.

In some embodiments, determining whether 240 a stitching area fulfils a predetermined criterion may comprise determining a value for a stitching metric and evaluating whether this fulfils a predetermined criterion. A value for the stitching metric may be obtained by determining a trench or line minimum width using a method according to an embodiment of the third aspect of the present invention. Particular features and advantages will be described in more detail in embodiments of the third aspect.

One example of a quantitative assessment of the stitching points may comprise determining a stitching width for a stitching region and evaluating whether the stitching width, for example being defined as the smallest internal distance between merged contours of the design features patterned in the first patterning step and the design features patterned in the second patterning step, is larger than a predetermined value, evaluating whether the edge placement error in a stitching width is smaller than a predetermined value, etc. As will be illustrated below, other measures for quantitative assessment also may be used. An advantage of methods and systems for determining a smallest internal distance is that the minimum direction can be captured in any direction. The latter is advantageous over for example standard SEM measurement techniques which are capturing in X or Y directions solely and therefore are not or less suited for 2D inspection, e.g. stitching inspection.

In another example edge placement error (EPE) data is collected for at least one edge of the lithographic pattern and the data is used for deriving a quality of the stitching in the stitching region. The data may be collected along at least one edge of the lithographic pattern but advantageously along a plurality of edges or along each edge of the lithographic pattern. The edge placement error (EPE), being a measure for the difference between the position as in the design and the position in the obtained pattern, may be collected for a plurality of points along the edge or edges. In one embodiment, determining whether or not the lithographic pattern is within the required specifications may be performed by determining an edge placement error and evaluating whether it is below a predetermined threshold. In some embodiments, the EPE data or a property related thereto may be used as stitching metric, whereby the EPE data is collected as function of the position along the edge. Depending on the shape of the resulting curve expressing the EPE as function of the position along the edge, the stitching metric may indicate that requirements are met or not met. In some embodiments, the edge placement error may be evaluated along the edge and the occurrence of local variations with a predetermined amplitude may be used as indication of a lowered stitching quality, e.g. as indication of the occurrence of necking. The threshold used for evaluating an EPE value or a change, e.g. local change may be determined based on earlier experiments, may be calculated or may be a predetermined value. As a general edge placement error not related to a stitching error may be present along the full edge, a resulting DC component in the edge placement error may be taken into account for determining the threshold value for evaluating the edge placement error, such that this DC component does not substantially influence evaluation of the stitching quality based on the edge placement error. In some embodiments, evaluation of a stitching quality may comprise determining an edge placement error along a first edge and along a second edge in the stitching region opposite to the first edge and combining the obtained edge placement error data so as to derive a stitching parameter.

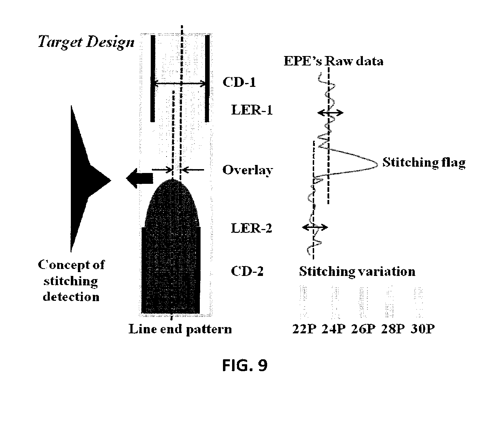

An example of the use of EPE data for evaluating stitching is schematically illustrated in FIG. 9. A target design is aligned with a lithographic pattern comprising a first lithographic pattern and a second lithographic pattern. For this example there is no overlap between the first and the second lithographic pattern at the stitching region. By measuring EPE along at least one edge of the lithographic pattern, one can define a stitching metric. A peak value in the corresponding curve representing EPE as function of position along the edge will be seen at the location where there is no overlap between the first and the second lithographic pattern, as such indicating a bad stitching. The stitching metric may comprise flagging the stitching, i.e a flag for bad stitching, no flag for good stitching. In some embodiments, if for example a local peak is seen in the EPE data, a bad stitching is flagged. Evaluation of the occurrence of a peak may be performed taking into account predetermined rules or based on previously measured data. An increase or decrease in measurement value may for example be considered a peak if the intensity variation is larger than a predetermined value.

Whether a stitching is good or bad may be dependent on the target design. Whether good or bad stitching is obtained may be determined taking into account the size of the design data.

In some embodiments, for evaluating the EPE data, side effects such as line edge roughness (LER) influences and critical dimension (CD) influences also may be taken into account.

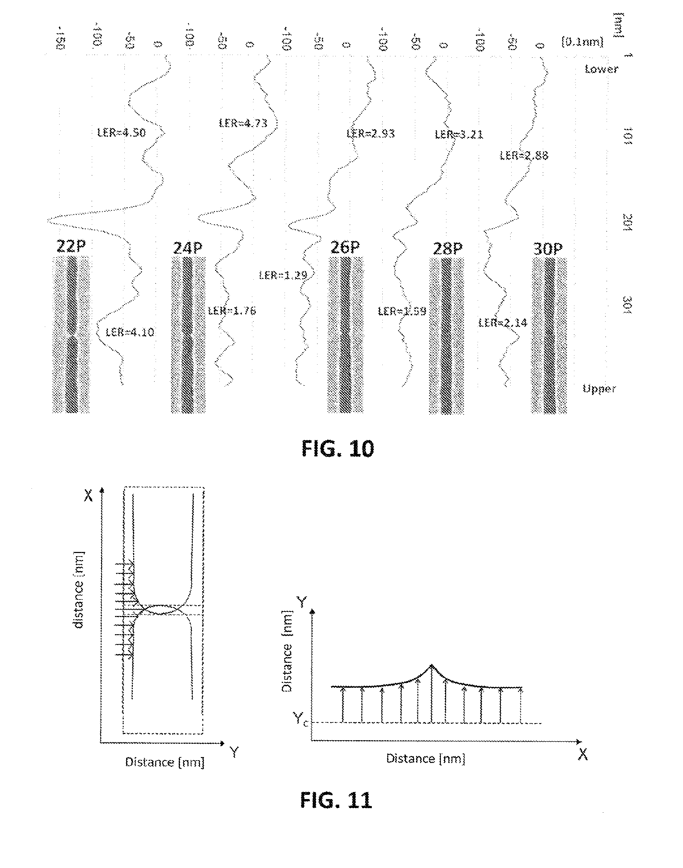

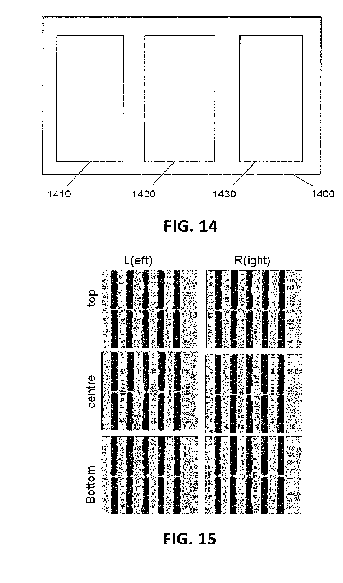

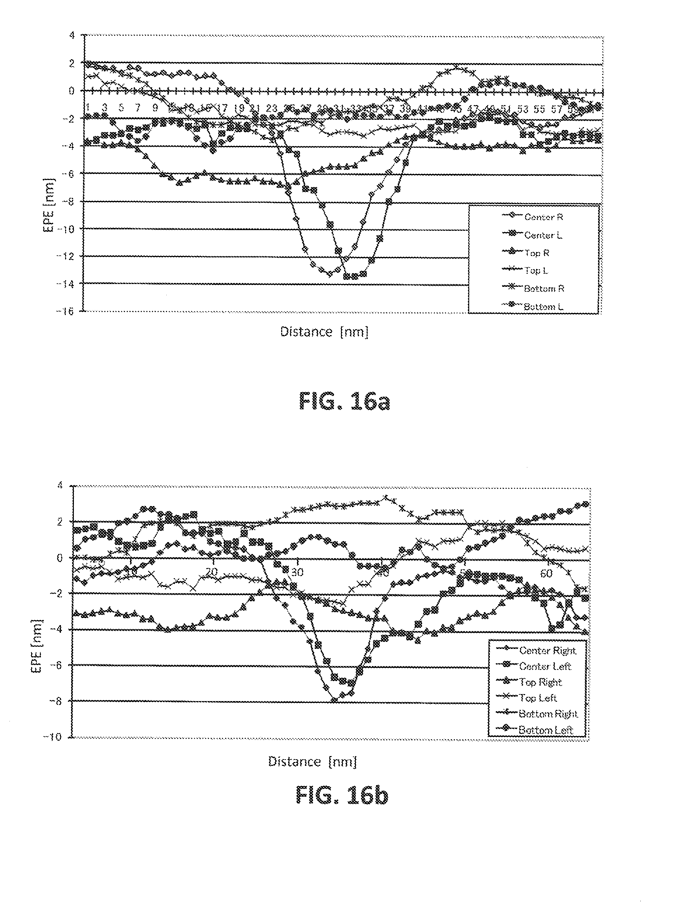

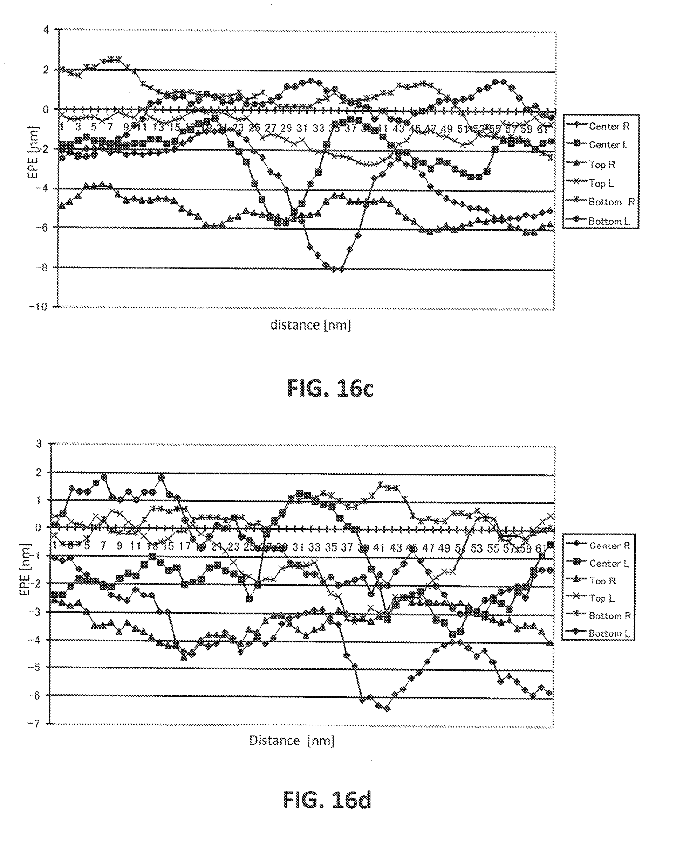

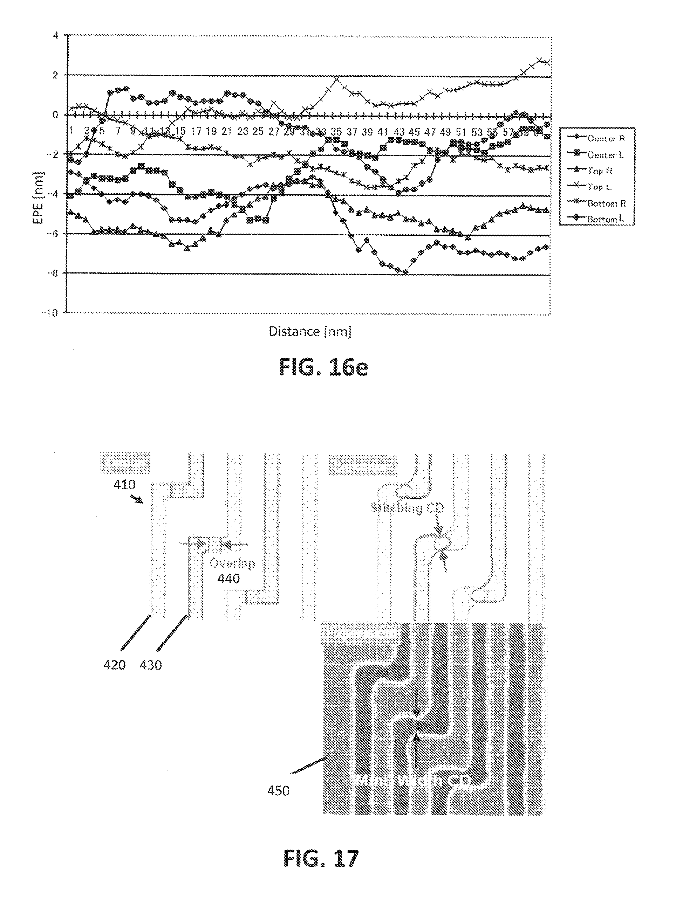

By way of illustration, the present invention not being limited thereto, experimental results for determination of the quality of stitching for a lithographic pattern is shown in FIG. 10, embodiments of the present invention not being limited thereto. A method using EPE data as function of their collection position along an edge is applied for a line pattern as shown in FIG. 4. Different line patterns have been processed under different conditions. By way of illustration FIG. 16a to FIG. 16e show EPE data measured at different positions on the edge of a line made using double patterning. The different lines are indicated in FIG. 15 illustrating a set of five lines wherein the overlay between the two constituting sub-patterns is varied. The indications "centre L" and "centre R" indicate the EPE data obtained at the stitching region where the two sub-patterns contribute respectively measured at the left hand side and the right hand side, whereas the indications "top L" and "top R" and "bottom L" and "bottom R" are indications for EPE data obtained at the top where only a first sub-pattern contributes and at the bottom where only a second sub-pattern contributes, the indications "L" and "R" indicating EPE data for the edge at the left hand side and the right hand side respectively. The corresponding positions at which EPE data are captured are indicated in FIG. 15. It can be seen in FIG. 16a to FIG. 16e that at the stitching region ("center"), depending on the overlay used, a peak occurs indicating a less optimum stitching or that no substantial peak can be distinguished, indicating better stitching. The EPE data in the example discussed above are collected as a one dimensional array, i.e. along a line following the edge made. In an embodiment according to the present invention, also two dimensional EPE data can be collected by scanning an area of interest. Evaluation of the data obtained, e.g. represented as a topological surface, can result in a two dimensional evaluation of the stitching quality. It is to be noticed that the present technique is especially suitable if information, such as a critical dimension error, overlay error, roughness or stitching information can be deconvolved out of the EPE histogram. Furthermore, usefull information especially is obtained in case two opposite, also referred to as facing edges, can be correlated with each other. From such a correlation, for example also a stitching width may be derived.

In one example peaks can be detected above the noise level. EPE data is collected using a CD-SEM technique whereby the target design is aligned with the obtained lithographic patterns. It can be seen that for different processing conditions different stitching situations are obtained, varying from no overlap or contact, over contact, to overlapping lithographic pattern features. Where there is no overlap between the first and the second lithographic pattern and thus bad stitching between the first and the second lithographic pattern, one can identify a large peak in the EPE histogram, whereas almost no peak is detected where a good stitching occurred.

Further by way of illustration, a schematic example of the EPE data that is obtainable is shown for two different stitching situations. FIG. 11 illustrates stitching of two line ends wherein overlap is present but wherein no overlay is present, i.e. the center axes of the lines coincide. The latter results in EPE data collected at one edge of the overall patterned line (the other edge providing similar results) which shows a small peak around the stitching area on a constant baseline (with reference to a reference value Y_{C}) at positions further away from the stitching area. EPE data can also be collected for both edges of a line, whereby different baseline values may be used. Both separate EPE data and the combination thereof provides an indication of the quality of the stitching. FIG. 11 illustrates that EPE data can be used for evaluating stitching quality and for indicating different types of stitching errors induced.

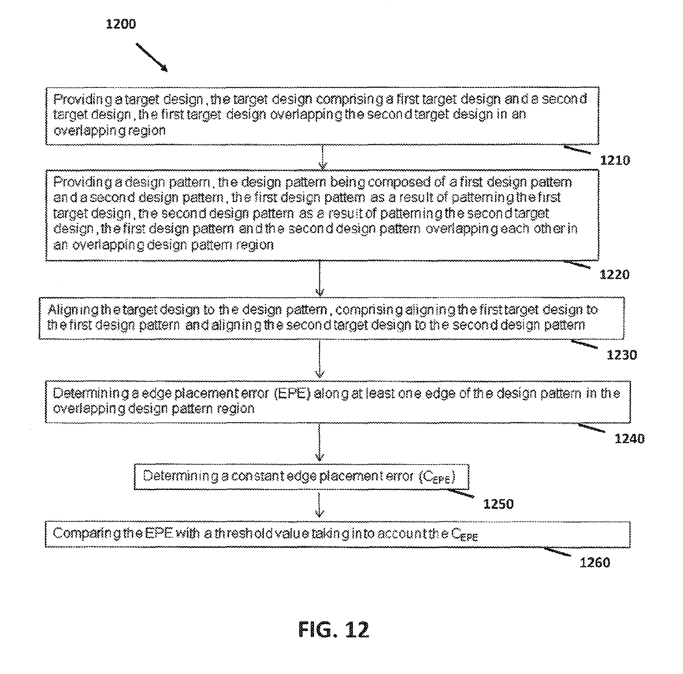

By way of illustration, the present invention not being limited thereto, a method for evaluating a lithographic design using EPE data collection is schematically shown in FIG. 12. The method 1200 comprises providing 1210 a target design 410 whereby the target design 410 comprises a first design 420 and a second design 430 for use in multiple patterning. The first design 420 and second design 430 typically may overlap in an overlapping region 440, so that upon finalizing the multiple patterning lithography, features of the first design 420 and of the second design 430 can combine in an overall target feature. The method 1200 furthermore may comprise performing the multiple patterning lithography process for generating an overall pattern. The process typically may comprise generating 1220 a first pattern as a result of patterning the first design 420 and generating a second pattern as a result of patterning the second design 430. Depending on the stitching that is performed, the first and the second pattern may show no overlap or may show overlap, and may show overlay shift or no overlay. In order to evaluate the quality of the stitching, the method further comprises aligning 1230 the target design 410 to the lithographic pattern. In the present exemplary method, aligning 1230 the target design 410 to the lithographic pattern comprises aligning the first design 420 to the first pattern and aligning the second design 430 to the second pattern. The method 1200 than further comprises identifying a stitching region based on the overlap in the aligned designs. In the stitching region, an edge placement error is determined 1240 along at least one edge of the lithographic pattern in the stitching region. Typically a constant edge placement error may be present and determined 1250, which may be referred to as C_{EPE}. For evaluating the stitching quality, the obtained EPE data is compared 1260 with a threshold value taking into account the constant edge placement error value, and depending on whether the threshold is reached or not, the stitching is flagged as bad or good.

The predetermined requirements and predetermined threshold values as referred above may be determined based on previous experiments, calculated values, results obtained via neural networks, etc.

Embodiments of the methods as described above may be adapted for being performed in an automated manner and/or automatically. The method may for example be performed using a predetermined algorithm.

Embodiments of the method as described above also encompass a method for inspecting a wafer, whereby the wafer comprises at least one lithographic pattern and whererin the method comprises evaluating the at least one lithographic pattern as described above.

In a second aspect, the present invention relates to a method for evaluating a multiple patterning lithographic process. The method comprises making a lithographic pattern using the multiple patterning lithographic process to be evaluated. The method furthermore comprises performing a method for evaluating a lithographic pattern according to a method as described in the first aspect. The method furthermore comprises determining, based on the evaluation, whether the multiple patterning lithographic processing fulfills predetermined requirements. If this is not the case, the method furthermore may comprise adjusting one or more lithographic processing parameters such as for example the design split used and repeating the evaluation process, thus resulting in a method for optimizing a multiple patterning lithographic process. It is an advantage of embodiments of the present invention that an improved or optimized multiple patterning lithographic process can be obtained. Other features and advantages may be as set out in the first aspect of the present invention.

According to a third aspect, the present invention also relates to an inspection system for evaluating a lithographic pattern. Such a lithographic pattern may be obtained using multiple patterning lithographic processing according to a target design, whereby the target design is composed of a first design and at least a second design. By way of illustration, basic components of the inspection system are shown in FIG. 14. The inspection system 1400 comprises an aligning module 1410 adapted for aligning the target design with the lithographic pattern, an identification module 1420 adapted for identifying a stitching region in the lithographic pattern based on a region of overlap of the first design and the second design in the target design aligned with the lithographic pattern and a determination module 1430 adapted for determining for the identified stitching region in the lithographic pattern whether a predetermined criterion is fulfilled. Other optional components comprising part or full of the functionality of the optional method steps as described in the first aspect also may be present.

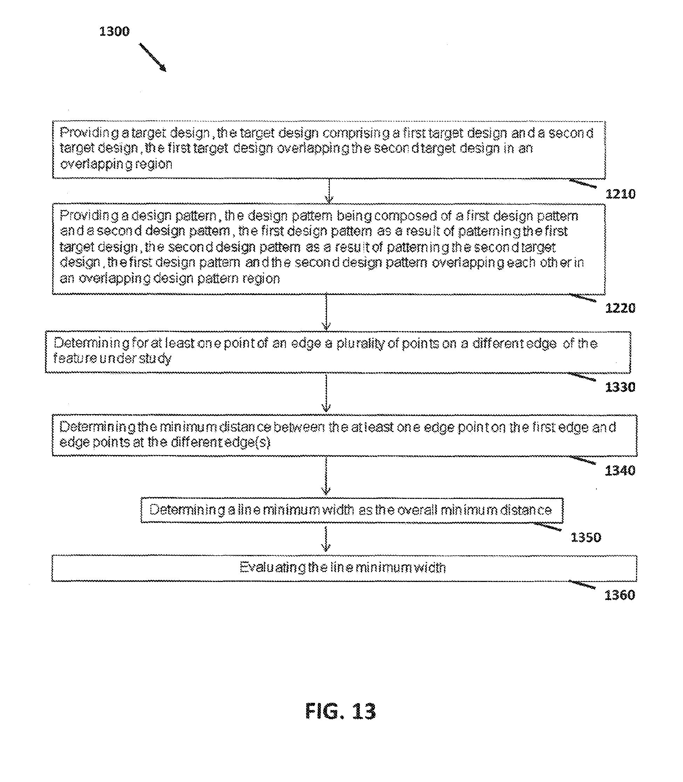

In a fourth aspect, the present invention also relates to a method and system for determining a trench or line minimum width in a critical area. Such a method 1300 may for example be applied for determining a stitching metric to measure a stitching quality on a wafer made by multiple patterning processes, although the method or system are not limited thereto. Methods and systems may not only be applied to a stitching area, but also to other lithographically critical areas or electrically critical areas. The first two steps may be similar to the steps described in FIG. 12. A value for a trench or line minimum width may be obtained by determining 1330 for at least one edge point on a first edge, a plurality of edge positions on a different edge of the feature under study, e.g. a line obtained by multiple patterning using stitching, and determining the minimum distance between the at least one edge point on the first edge and the edge positions of the different edges. The different edges thereby may be opposite edges forming the feature. Determining 1340 the minimum distance between edge positions of different edges may be performed by, for the at least one edge position on the first edge, determining the distance to individual edge positions of a different edge, e.g. an edge opposite thereto, and selecting from all obtained values the minimal distance value obtained. The trench or line minimum width can then be identified as the line corresponding with this minimal value. If on the first edge more edge positions are identified, the trench or line minimum width can be identified 1350 as the line corresponding with the overall minimum value. This minimum distance is not restricted to a preferred direction, on the contrary to traditional SEM measurement techniques. More particularly, the method of determining minimal distance values can be applied in any or a combination of directions and is not restricted to the X or Y measurement direction. The metric also may be referred to as the minimal width critical dimension of the feature. The line minimum width then also may be evaluated 1360. For determination of the distance, critical dimension SEM may for example be used in combination with image processing on a computing device. By way of illustration, the present invention not being limited thereto, a method for evaluating a lithographic design using the minimal distance technique as described above is schematically shown in FIG. 13.

It is to be noticed that in advantageous embodiments making use of determination of the minimal width critical dimension, the local orientation of the feature can be taken into account for determining the edge points of the different edges. For example, the direction wherein a line is oriented may be taken into account for determining the plurality of edge points of the different edges. By taking this orientation into account, a technique is provided for determining or measuring a trench or line minimum width in any direction. The latter is advantageous as most patterned features are not fully oriented along one single direction, but e.g. corners or zigzag lines may occur. The edge points may for example be selected as those edge points lying in a selected identification region, the identification region being oriented taking into account the local orientation of the feature. The identification region may for example be a square or rectangle, whereby a length direction of the identification region is chosen along the local orientation direction of the feature. The latter will be illustrated in more detail in an example below.

Examples of embodiments wherein the minimal width critical dimension of the feature is used are shown below, by way of illustration for the application of evaluating stitching. FIG. 17 illustrates the principle of the minimum stitching width which can be used as metric for evaluating stitching quality. FIG. 17 illustrates the minimum stitching width in a simulated pattern and an experiment for a stitching overlap as shown in the illustrated design.

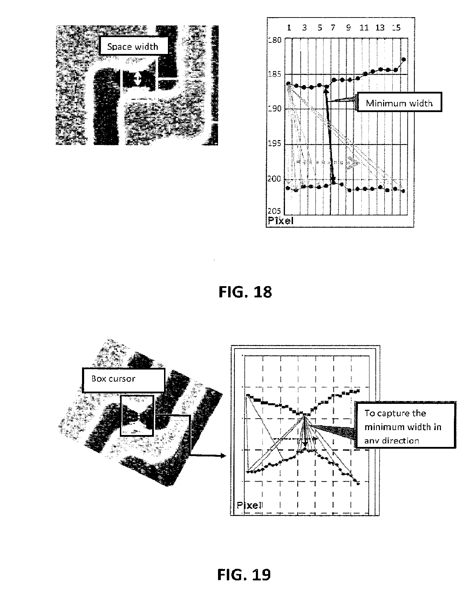

A method as described in one embodiment above is illustrated in FIG. 18, whereby a number of edge points are identified on the edges of the feature, in the present example being a zigzag line. In the present example 16 points per edge are determined, embodiments of the present invention not being limited thereto. For each determined edge position on a first edge, the distance to each of the points on the other edge, being opposite to the first edge, is determined. From the different distances, the minimum value is determined. Such processing may be performed in an automated and/or automatic way, e.g. using dedicated software or hardware, although the invention is not limited hereto. In FIG. 19, another example is shown, whereby for the selection of the edge positions, the orientation of the line feature is taken into account. In the example shown, the local orientation of the line is different from the direction in the major part of the zigzag line feature. The selection region may be selected such that distances are measured in all directions where neighboring edge points of different edges are present. In other words the selection region should be selected such that measurement in all directions should be possible. For the examples described above, 45nm trenches were used, manufactured using a double patterning technique. The patterning was performed with a numerical aperture of 1.2, annular irradiation 0.92 - 0.72 and using X/Y polarization. Measurements were performed using CD-SEM and design gauge. The SEM conditions used were 500V under vacuum conditions, a current of 8pA, a magnification of x100.

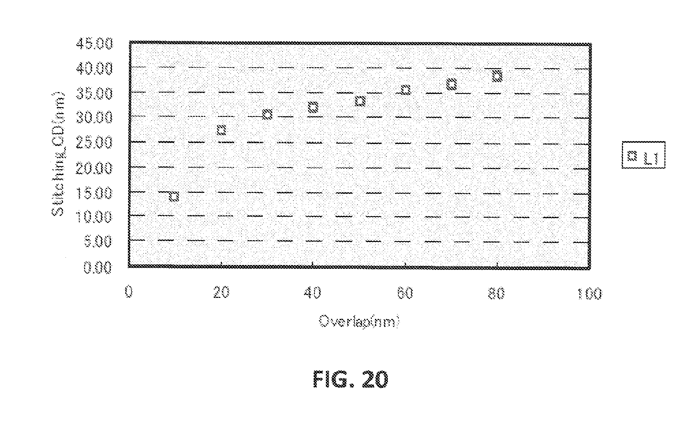

In FIG. 20 results are shown of the tailoring of a double patterning technique whereby for different amounts of overlap, the line minimal width is determined in the overlap region. FIG. 20 illustrates the line minimal width as function of the overlap provided for in the design. It can be seen that with a larger overlap, the line minimal width increases. Evaluation of the stitching may be performed e.g. by indicating that a predetermined value should at least be reached by the line minimal width in order to qualify the result as appropriate stitching. Using a graph as shown in FIG. 20, the minimum overlap to be used may be determined, more generally thus determining the processing and/or design conditions based on the evaluation of the stitching.

In further aspects, embodiments of the present invention also relate to computer-implemented methods for performing at least part of the methods for evaluating lithographic patterns as described above or to corresponding computing program products. Such methods may be implemented in a computing system, such as for example a general purpose computer. The computing system may comprise an input means for receiving data, partly processed data or processed data from an evaluation tool and a processing means for processing the obtained data in agreement with the above method. The system may be or may comprise a data processor and may be part of or may be the inspection system as described in the third aspect. The computing system may include a processor, a memory system including for example ROM or RAM, an output system such as for example a CD-rom or DVD drive or means for outputting information over a network. Conventional computer components such as for example a keyboard, display, pointing device, input and output ports, etc also may be included. Data transport may be provided based on data busses. The memory of the computing system may comprise a set of instructions, which, when implemented on the computing system, result in implementation of part or all of the standard steps of the methods as set out above and optionally of the optional steps as set out above. Therefore, a computing system including instructions for implementing part or all of a method for evaluating the lithographic pattern is not prior art.

Further aspect of embodiments of the present invention encompass computer program products embodied in a carrier medium carrying machine readable code for execution on a computing device, the computer program products as such as well as the data carrier such as dvd or cd-rom or memory device. Aspects of embodiments furthermore encompass the transmitting of a computer program product over a network, such as for example a local network or a wide area network, as well as the transmission signals corresponding therewith.

The foregoing description details certain embodiments of the invention. It will be appreciated, however, that no matter how detailed the foregoing appears in text, the invention may be practiced in many ways. It should be noted that the use of particular terminology when describing certain features or aspects of the invention should not be taken to imply that the terminology is being re-defined herein to be restricted to including any specific characteristics of the features or aspects of the invention with which that terminology is associated.

While the above detailed description has shown, described, and pointed out novel features of the invention as applied to various embodiments, it will be understood that various omissions, substitutions, and changes in the form and details of the device or process illustrated may be made by those skilled in the technology without departing from the spirit of the invention.

## Claims

1. A method (200) of evaluating a lithographic pattern, the lithographic pattern (450) being obtained using multiple patterning lithographic processing according to a target design (410) composed of a first design (420) and at least a second design (430), the method (200) comprising: aligning (220) the target design (410) with the lithographic pattern (450), identifying (230) a stitching region in the lithographic pattern based on a region of overlap (440) of the first design (410) and the second design (420) in the target design aligned with the lithographic pattern (450), and determining (240) for the identified stitching region in the lithographic pattern whether a predetermined criterion is fulfilled.

2. A method (200) according to claim 1, wherein aligning (220) the target design (410) with the lithographic pattern (450) comprises aligning the first design (420) to a first set of lithographic pattern features and/or aligning the second design (430) to a second set of lithographic pattern features, thus distinguishing the first set of lithographic pattern features generated using the first design (420) and the second set of lithographic pattern features generated using the second design (430) on the lithographic pattern (450).

3. A method (200) according to any of the previous claims, wherein aligning (220) comprises extracting a position of an edge of the lithographic pattern based on an image thereof, and combining the target design (410) and the image of the lithographic pattern (450) taking into account the extracted position of the edge.

4. A method (200) according to any of the previous claims, wherein determining (240) for the identified stitching region in the lithographic pattern (450) whether a predetermined criterion is fulfilled comprises determining a line or trench minimum width.

5. A method (200) according to any of the previous claims, wherein determining a line or trench minimal width comprises determining at least one edge position on a first edge of a pattern and a plurality of edge positions on a different edge facing the first edge, determining values for the plurality of distances between the at least one edge position on the first edge and the plurality of edge positions on the different edge, selecting a minimum value from said determined values as the line or trench minimum width.

6. A method (200) according to any of the previous claims, wherein determining (240) for the identified stitching region in the lithographic pattern (450) whether a predetermined criterion is fulfilled comprises determining a stitching metric for the identified stitching region and evaluating whether or not the stitching metric fulfills a predetermined criterion.

7. A method (200) according to any of the previous claims, wherein determining a stitching metric comprises determining an edge placement error (1240) along at least one edge of the lithographic pattern in the stitching region and evaluating (1260) whether the edge placement error is below a predetermined threshold for the edge placement error.

8. A method (200) according to any of the previous claims, the method (200) comprising determining (1330) for a plurality of points on the at least one edge of the lithographic pattern an edge placement error and taking the edge placement errors into account for determining the predetermined threshold value (1340) for edge placement errors.

9. A method (200) according to any of the previous claims, wherein the method (200) further comprises, based on said evaluating, deciding that necking problems are present due to stitching when a local deviation of the edge placement error is larger than the predetermined threshold.

10. A method (200) according to any of the previous claims, wherein determining a stitching metric furthermore comprises determining an edge placement error along a second edge in the stitching region opposite the at least one edge, evaluating an edge placement error for the second edge and combining information regarding the edge placement error of the at least one edge and the edge placement error of the second edge.

11. A method (200) according to any of claims 1 to 10, wherein the method (200) further comprises obtaining a detailed image of the identified stitching region.

12. A method (200) according to any of the previous claims, wherein the method (200) comprises for the distinguished first set of lithographic pattern features and second set of lithographic pattern features separately determining whether a predetermined criterion is fulfilled.

13. A method of evaluating a multiple patterning lithographic process, the method comprising making a lithographic pattern using the multiple patterning lithographic process, performing a method of evaluating a lithographic pattern (200) according to any of claims 1 to 12, and determining based thereon whether the multiple patterning lithographic process fulfills predetermined requirements.

14. A method of optimizing a multiple patterning lithographic process, the method comprising a method (200) of evaluating a lithographic pattern according to any of claims 1 to 12 for evaluating a multiple patterning lithographic process and adjusting one or more of the process parameters of the multiple patterning lithographic process if it is found that the predetermined requirements are not fulfilled.

15. An inspection system (1400) for evaluating a lithographic pattern, the lithographic pattern (450) being obtained using multiple patterning lithographic processing according to a target design (410) composed of a first design (420) and at least a second design (430), the inspection system (1400) comprising an aligning module (1410) adapted for aligning the target design (410) with the lithographic pattern (450), an identification module (1420) adapted for identifying a stitching region in the lithographic pattern based on a region of overlap (440) of the first design (420) and the second design (430) in the target design (410) aligned with the lithographic pattern (450), and a determination module (1430) adapted for determining for the identified stitching region in the lithographic pattern (450) whether a predetermined criterion is fulfilled.
